# EUROPEAN PATENT APPLICATION

(11) **EP 4 191 822 A1**
(43) Date of publication of application: **07.06.2023**
(21) Application number: 22756548.8
(22) Date of filing: 18.02.2022
(51) Int. Cl.: H02J 7/00, G01R 31/382

(54) **BATTERY PROTECTION CIRCUIT HAVING SECONDARY PROTECTION IC FUNCTION, METHOD FOR MEASURING VOLTAGE OF SERIES-CONNECTED CELLS USING SAME, AND BATTERY PROTECTION METHOD**

(30) Priority: 18.02.2021 KR 20210021899
(71) Applicant: LG Energy Solution, Ltd., Seoul 07335 (KR)
(72) Inventor: LEE, Jong Kyung, Daejeon 34122 (KR)
(74) Representative: Plasseraud IP
(86) International application number: PCT/KR2022/002428
(87) International publication number: WO 2022/177350

(57) **Abstract**

The present invention relates to a battery protection circuit implementing a secondary protection IC function and a voltage measurement method of series-connected cells using the same, and more particularly, to a battery protection circuit that implements a secondary protection IC function that measures the voltage of series-connected cells using a switch and an MCU without a separate secondary protection IC, and a voltage measurement method for series-connected cells using the same.

## Description

### TECHNICAL FIELD

The present invention relates to a battery protection circuit and a voltage measurement method for series-connected cells using the same, and more particularly, to a battery protection circuit implementing a secondary protection IC function for measuring the voltage of battery cells connected in series without a secondary protection IC, and a measurement method thereof.

### BACKGROUND ART

The battery protection circuit 10 applied to the battery pack is configured with an AFE (monitoring IC) 11 that monitors the state of the battery in order to protect the battery from abnormal problems such as overcharging and overdischarging. In addition, a component 12 for secondary protection for secondary monitoring of the voltage state of the battery is separately provided so that the battery can be normally protected from an abnormal problem even when the AFE (monitoring IC) does not operate normally.

As a component for such secondary protection, in general, a separate AFE is additionally used for an automobile battery pack, and a hardware-based secondary protection IC is used for a small electronic device such as a notebook computer.

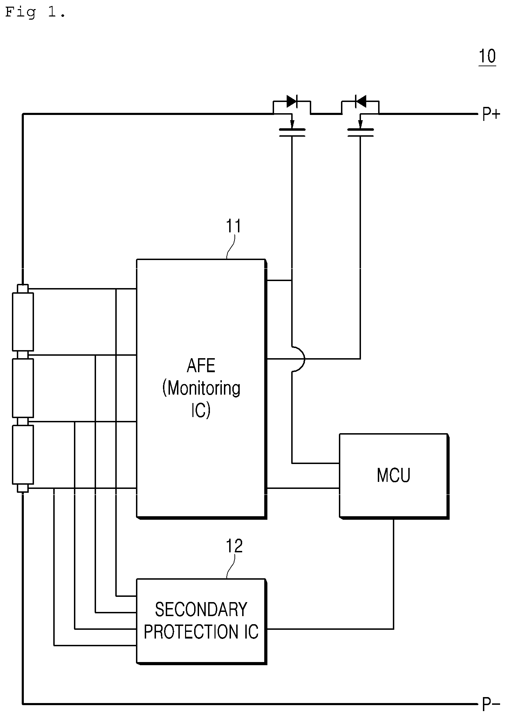

FIG. 1 is a diagram schematically illustrating a battery protection circuit used in a conventional battery pack for LEV. A battery pack for Light Electric Vehicle (LEV) mounted on a light electric vehicle such as an electric scooter or an electric bicycle uses a secondary protection IC 12 in case of dual application of AFE, such as in automotive battery packs, due to the price problem, in most cases, as shown in FIG. 1.

However, secondary protection ICs are relatively vulnerable to electromagnetic compatibility (EMC), and thus there is an issue of causing various problems in a manufacturing process or an actual use area.

As a related prior art, there are the following patent documents.
(Patent Document 1) KR1244493 B1

### DISCLOSURE OF THE INVENTION

### TECHNICAL PROBLEM

The present invention is to solve the above-mentioned problem, and provides a battery protection circuit for a battery pack for LEV that is cheaper than secondary protection IC and has a secondary protection IC that is strong against electromagnetic compatibility (EMC), and a voltage measurement method for series-connected cells using the same.

### TECHNICAL SOLUTION

According to the present invention, a battery protection circuit configured in a battery pack in which N (N ≥ 2) battery cells are connected in series with each other, and a negative pole (-) of a first cell at the lowest end among the battery cells is connected to a ground (GND) includes: a plurality of primary sensing lines connected between positive/negative electrodes (+, -) of each battery cell and a monitoring IC; the monitoring IC configured to perform primary monitoring by measuring a voltage of each of the battery cells through the plurality of primary sensing lines; a plurality of secondary sensing lines connected to each of the primary sensing lines; a switch configured to connect one sensing line among the secondary sensing lines and the MCU; and the MCU configured to measure the ground (GND) and a positive electrode (+) voltage of each battery cell with a secondary sensing line connected through a control of the switch, and perform secondary monitoring by sequentially calculating voltages of the first cell to the N-th cell based on the measured ground (GND) and positive electrode (+) voltages of the battery cells.

In detail, the plurality of primary sensing lines includes: a primary first sensing line having one end connected to the negative electrode (-) of the first cell and the other end connected to the monitoring IC; a primary N-th sensing line having one end connected between the positive electrode (+) of the first cell and the negative electrode (-) of the N-th cell connected to an upper end of the first cell and the other end connected to the monitoring IC; and a primary (N+1)-th sensing line having one end connected to the positive electrode (+) of the N-th cell and the other end connected to the monitoring IC.

Moreover, the plurality of secondary sensing lines include: a secondary first sensing line having one end connected to the primary first sensing line and the other end connected to the MCU through a switch to sense a ground (GND) voltage; a secondary N-th sensing line having one end connected to the primary N-th sensing line and the other end connected to the MCU through a switch to sense the positive electrode (+) voltage of the first cell; and a secondary (N+1)-th sensing line having one end connected to the primary (N+1)-th sensing line and the other end connected to the MCU through a switch to sense the positive electrode (+) voltage of the N-th cell.

Moreover, the MCU includes: a switch control unit configured to sequentially locate the switch alternately from the secondary first sensing line and the secondary N-th sensing line to the (N+1)-th sensing line; a cell voltage measurement unit configured to measure ground (GND) and positive electrode (+) voltages of a corresponding battery cell with a secondary sensing line connected through a switch under the control of the switch control unit; a cell voltage calculation unit configured to sequentially calculate voltage values from the first cell to the N-th cell using the ground (GND) and positive electrode (+) voltages of the battery cells measured by the cell voltage measurement unit; and a secondary monitoring unit configured to perform secondary monitoring of voltage states of the battery cells based on respective voltage values of the first to N-th cells calculated by the cell voltage calculation unit.

Accordingly, the cell voltage calculation unit calculates the voltage value of the first cell from the positive electrode (+) voltage of the first cell and the ground (GND) measured by the cell voltage measurement unit, calculates the voltage summation values of the first to N-th cells with the positive electrode (+) voltage of the N-th cell and the ground (GND) measured by the cell voltage measurement unit, and calculates the voltage value of the N-th cell by subtracting the voltage summation values of the first to (N-1)-th cells from the calculated voltage summation values of the first to N-th cells.

According to the present invention, a method of measuring a voltage of an N-th cell from a first cell at the lowest end among battery cells by using a switch connecting an MCU and a voltage sensing line connected to each of N (N ≥2) battery cells connected in series includes: a first cell voltage measurement step of sequentially positioning the switch to the voltage sensing line connected to a negative electrode (-) of the first cell connected to the ground (GND) and the positive electrode (+) of the first cell, respectively, to measure the voltage value of the first cell with the ground (GND) and the positive electrode (+) voltage of the first cell through the switch; and an N cell voltage calculation step of sequentially positioning the switch to a voltage sensing line connected to the negative electrode (-) of the first cell connected to the ground (GND) and the positive electrode (+) of the N-th cell connected to the upper end of the first cell, respectively.

Here, the N-th cell voltage calculation step includes: measuring the voltage summation values of the first to N-th cells with the ground (GND) and the positive electrode (+) voltage of the N-th cell, and calculating the voltage value of the N-th cell by subtracting the voltage summation values of the first to (N-1)-th cells from the measured first to N-th cells voltage summation values.

According to the present invention, a battery protection method for protecting N (N≥2) battery cells connected in series includes: a first voltage measurement step of measuring a primary voltage of each of the battery cells through a primary sensing line connected to each battery cell in a monitoring IC; a second voltage measurement step of controlling a switching circuit connecting between an MCU and any one of secondary sensing lines connected to the primary sensing lines, and measuring a secondary voltage of each of the battery cells through the connected secondary sensing line; a comparison step of comparing a primary voltage of the monitoring IC with a secondary voltage of the MCU and comparing whether a deviation is greater than or equal to a predetermined deviation reference range; and an error determination step of providing a notification alert by determining that an error has occurred in either one of the monitoring IC and the MCU when the comparison result of the comparison step is greater than or equal to a predetermined deviation reference range.

In more detail, the second voltage measurement step includes: a voltage measurement step of sequentially positioning, by the MCU, the switch to a secondary sensing line connected to a negative electrode (-) of the first cell connected to the ground (GND) and the positive electrode (+) of the first cell, respectively, to measure a voltage value of the first cell with a ground (GND) and a positive electrode (+) voltage of the first cell through the switch; and an N-th cell voltage calculation step of sequentially positioning, by the MCU, the switch to a secondary sensing line connected to the negative electrode (-) of the first cell connected to the ground (GND) and the positive electrode (+) of the N-th cell connected to the upper end of the first cell, respectively to calculate a voltage value of the N-th cell using the ground (GND) and the positive electrode (+) voltage of the N-th cell through the switch.

Here, the N-th cell voltage calculation step includes measuring the voltage summation values of the first to N cells with the ground (GND) and the positive electrode (+) voltage of the N-th cell, and calculating the voltage value of the N-th cell by subtracting the measured first cell voltage value from the measured first N-th cells voltage summation values.

### ADVANTAGEOUS EFFECTS

In the present invention, there is no need to provide a separate secondary protection IC by replacing the function of the secondary protection IC using a switch and an MCU.

Therefore, it is possible to provide a battery protection circuit including a secondary protection IC function that is inexpensive compared to the secondary protection IC and is strong against electromagnetic.

### BRIEF DESCRIPTION OF THE DRAWINGS

FIG. 1 is a view showing a conventional battery protection circuit.
FIG. 2 is a diagram illustrating a battery protection circuit according to the present invention.

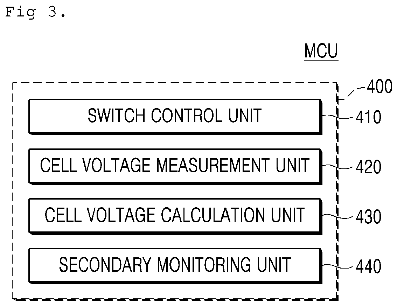

FIG. 3 is a diagram illustrating a detailed configuration of an MCU according to the present invention.

### MODE FOR CARRYING OUT THE INVENTION

Hereinafter, embodiments of the present invention will be described in detail with reference to the accompanying drawings so that those of ordinary skill in the art may easily implement the present invention. However, the present invention may be implemented in various forms and is not limited to the embodiments described herein. In the drawings, parts irrelevant to the description are omitted in order to clearly describe the present invention, and like reference numerals refer to like elements throughout the specification.

Hereinafter, the present invention will be described in detail with reference to the drawings.

### 1. Battery Protection Circuit According To Present Invention

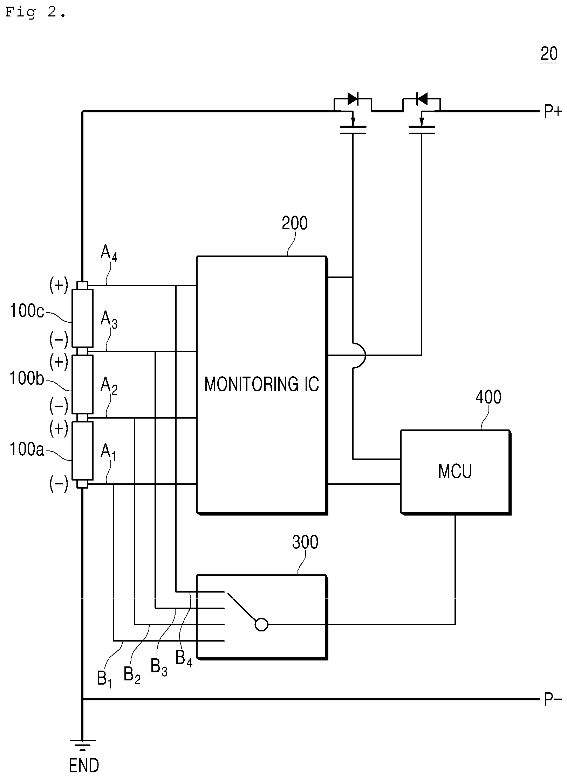

FIG. 2 is a diagram illustrating a battery protection circuit 20 according to the present invention. A battery protection circuit according to the present invention will be described with reference to FIG. 2.

In the present specification, a case in which three battery cells are connected in series as shown in FIG. 2 will be described, but the present disclosure is not limited thereto, and it is possible if two or more battery cells are connected in series.

### 1.1. Series Connected Battery Cells 100

The battery protection circuit of the present invention is connected to N (N≥2) battery cells connected in series.

If N (N≥2) battery cells are connected in series, among all battery cells, the first cell 100a, the second cell 100b, ... , may be referred to as an N-th cell (not shown) from the lowest connected battery cell to the top.

At this time, as shown in FIG. 2, the negative electrode (-) of the first cell 100a connected to the lowermost end among the battery cells connected in series is connected to the ground (GND).

### 1.2. Multiple Primary Sensing Lines

A plurality of primary sensing lines are connected between the series battery cells 100a to 100c and the monitoring IC 200 as shown in FIG. 2 to sense voltages of each of the battery cells 100.

Specifically, it is configured including a primary first sensing line A₁ having one end connected to the negative electrode (-) of the first cell 100a and the other end connected to the monitoring IC 200, a primary second sensing line A₂ having one end connected between the positive electrode (+) of the first cell 100a and the negative electrode (-) of the second cell 100b and the other end connected to the monitoring IC 200, a primary third sensing line A₃ having one end connected between the positive electrode (+) of the second cell 100b and the negative electrode (-) of the third cell 100c and the other end connected to the monitoring IC 200, and a primary fourth sensing line A₄ having one end connected to the positive electrode (+) of the third cell 100c and the other end connected to the monitoring IC 200.

If N (N≥2) battery cells are connected in series, N+1 primary sensing lines A₁ to A_{N+1} are connected.

The voltage state of each of the battery cells 100a to 100c can be primarily monitored by the monitoring IC 200 to be described later through the plurality of primary sensing lines A₁ to A₄.

### 1.3. Monitoring IC 200

The monitoring IC measures and monitors the voltage of each of the battery cells 100a to 100c connected in series through the plurality of primary sensing lines A₁ to A₄.

Such a monitoring IC is a known configuration and generally uses an AFE IC or an ASIC.

On the other hand, the monitoring IC is configured to include a communication unit (not shown) interconnected with the MCU 400 to be described later.

### 1.4. Multiple Secondary Sensing Lines

A plurality of secondary sensing lines are respectively connected to the primary sensing lines A₁ to A₄ to sense voltages of the battery cells 100a to 100c. As shown in FIG. 2, one end of each secondary sensing line is connected to each primary sensing line, and the other end is connected to a micro control unit (MCU) 400 through a switch 300 to be described later.

Specifically, it is configured including a secondary first sensing line B₁ having one end connected to the primary first sensing line A₁ and the other end connected to the MCU 400 through the switch 300, a secondary second sensing line B₂ having one end connected to the primary second sensing line A₂ and the other end connected to the MCU 400 through the switch 300, a secondary third sensing line B₃ having one end connected to the primary third sensing line A₃ and the other end connected to the MCU 400 through the switch 300, and a secondary fourth sensing line B₄ having one end connected to the primary fourth sensing line A₄ and the other end connected to the MCU 400 through the switch 300.

When N battery cells are connected in series, N+1 secondary sensing lines B₁ to B_{N+1} are connected to correspond to the primary sensing lines A₁ to A_{N+1}.

At this time, the secondary sensing line connected to the MCU 400 varies depending on at which the other end of a sensing line among the secondary first to (N+1)-th sensing lines the switch 300 is located.

### 1.5. Switch 300

The switch is a configuration to connect at least one sensing line among the secondary first to fourth sensing lines B₁ to B₄ and the MCU 400 under the control of the MCU 400 to be described later as shown in FIG. 2.

Specifically, under the control of the switch control unit 410 of the MCU 400 to be described later, the secondary first sensing line B₁ and the secondary second sensing line B₂ to the secondary fourth sensing line B₄ are alternately connected to the MCU 400.

Through such a switch, the MCU 400 can measure/calculate the voltage of each of the first to third cells 100a to 100c.

### 1.6. Micro Control Unit (MCU) 400

The MCU is a configuration to measure the ground (GND) and the positive electrode (+) voltage of each battery cell through the control of the switch 300, and secondary monitor the voltage state of the battery cells based on the voltage values of each of the battery cells calculated using the measured ground (GND) and positive electrode (+) voltages.

In other words, in case that the monitoring IC 200 does not operate normally, the switch 300 and the MCU 400 replace the secondary protection IC function provided in the existing battery protection circuit.

Here, in the voltage measurement method, unlike the conventional secondary protection IC that measures the positive electrode (+) and negative electrode (-) voltages of each battery cell, the MCU 400 of the present invention uses a method of measuring the ground (GND) and the positive electrode (+) voltage of the battery cell using the switch 300.

Meanwhile, the MCU 400 is configured to include a communication unit (not shown) that communicates with the monitoring IC 200 described above.

### A. Switch Control Unit 410

The switch control unit controls the switch 300 to be sequentially positioned alternately from the secondary first sensing line B₁ and the secondary second sensing line to the fourth sensing lines B₂ to B₄.

If N battery cells are connected in series, it is to control so that the switch 300 is alternately located on the secondary first sensing line B₁ and the secondary second sensing line t o the (N+1)-th sensing lines B₂ to B_{N+1} sequentially.

More specifically, the switch 300 locates secondary first sensing line B₁ -> secondary second sensing line B₂ -> secondary first sensing line B₁ -> secondary third sensing line B₃ -> secondary first sensing line B₁ -> secondary fourth sensing line B₄ in the order to sequentially connect the secondary sensing line and the MCU 400.

The reason for this control is that the voltage value of each battery cell is calculated by measuring the ground (GND) and positive electrode (+) voltages of the battery cells as described above.

### B. Cell Voltage Measurement Unit 420

The cell voltage measurement unit measures the sensing voltage of the secondary sensing line connected through the switch 300 under the control of the switch control unit 410.

More specifically, it is connected to secondary first sensing line B₁ -> secondary second sensing line B₂ -> secondary first sensing line B₁ -> secondary third sensing line B₃ -> secondary first sensing line B₁ -> secondary fourth sensing line B₄ through the switch 300. Accordingly, in the order of ground (GND) -> positive electrode (+) of the first cell 100a -> ground (GND) -> positive electrode (+) of the second cell 100b -> ground (GND) -> positive electrode (+) of the third cell 100c, a voltage thereof is measured.

Here, since the battery cells are connected in series, reading the ground (GND) the positive electrode (+) voltage of and the second cell 100b may refer to measuring the summed voltage of the first and second cells 100a and 100b, and reading the ground (GND) and the positive electrode (+) voltage of the N-th cell 100n may refer to measuring the summed voltage of the first, second, and third cells 100a to 100c.

### C. Cell Voltage Calculation Unit 430

The cell voltage calculation unit sequentially calculates from the voltage value of the lowermost first cell 100a using the ground (GND) and positive electrode (+) voltages measured by the cell voltage measurement unit 420.

First, the voltage value of the first cell 100a is calculated based on the ground (GND) and the positive electrode (+) voltage of the first cell.

Next, the voltage of the first cell 100a calculated above is subtracted from the sum of the voltages of the first and second cells 100a and 100b measured using the ground (GND) and the positive electrode (+) voltage of the second cell so that the voltage value of the second cell 100b may be calculated.

And, the sum of the voltages of the first and second cells 100a and 100b previously measured is subtracted from the sum of the voltages of the first, second, and third cells 100a to 100c measured using the ground (GND) and the positive electrode (+) voltage of the third cell so that the voltage value of the third cell 100c may be calculated.

With this principle, if N battery cells are connected in series, the sum of the voltages of the first to (N-1)-th cells measured using the ground (GND) and the positive electrode (+) voltage of the (N-1)-th cell is subtracted from the sum of the voltages of the first to N-th cells measured using the ground (GND) and the positive electrode (+) voltage of the N-th cell so that the voltage value of the N-th cell may be calculated.

### D. Secondary Monitoring Unit 440

The secondary monitoring unit may compare the voltage values of the respective battery cells calculated by the cell voltage calculation unit 430 with a predetermined reference range to secondary monitor the voltage state of the series-connected cells.

In addition, by comparing the measured voltage of the battery cells received from the monitoring IC 200 through the communication connection with the monitoring IC 200 and the voltage of the battery cells calculated by the cell voltage calculation unit 430 with each other, if the deviation is greater than or equal to the predetermined deviation range, it is determined that an error has occurred in any one of the monitoring IC 200 and the MCU 400 to provide a notification alert.

As described above, the battery protection circuit of the present invention can stably protect the battery from abnormal problems such as overcharging and overdischarging even when the monitoring IC does not operate normally by replacing the function of the secondary protection IC by using the switch 300 and the MCU 400 without having a secondary protection IC.

### 2. Voltage Measurement Method of Series-Connected Cells Using Battery Protection Circuit According to Present Invention

A method of measuring the voltage of series-connected cells using a battery protection circuit according to the present invention is configured to sequentially measure the voltage value of the first cell 100a connected to the lowermost stage among the battery cells using the switch 300 connecting between the voltage sensing line connected to each of the series-connected battery cells and the MCU 400.

### 2.1. First Cell Voltage Measurement Step

First, the voltage of the first cell 100a connected to the lowermost stage among the battery cells connected in series is measured. The method allows the switch 300 to be sequentially positioned at the secondary first sensing line B₁ connected to the negative electrode (-) of the first cell 100a connected to the ground (GND) and the secondary second sensing line B₂ connected to the positive electrode (+) of the first cell 100a so that the voltage value of the first cell is measured using the ground (GND) and the positive electrode (+) voltage of the first cell through the switch 300.

### 2.2. Second Cell Voltage Measurement Step

After measuring the voltage of the first cell 100a, which is the lowest cell, the voltage of the second cell 100b connected to the upper end of the first cell 100a is measured. The method allows the switch 300 to be sequentially positioned at the secondary first sensing line B₁ connected to the negative electrode(-) of the first cell 100a connected to the ground (GND) and the secondary third sensing line B₃ connected to the positive electrode (+) of the second cell 100b so that the sum of the voltages of the first and second cells is measured using the ground (GND) and the positive electrode (+) voltage of and the second cell through the switch 300. Then, by subtracting the voltage value of the first cell 100a previously measured in the first cell voltage measurement step from the measured voltage sum of the first and second cells 100a and 100b, the voltage value of the second cell 100b may be calculated.

### 2.3. Third Cell Voltage Measurement Step

Measuring the voltage of the third cell 100c includes sequentially positioning the switch 300 at the secondary first sensing line B₁ connected to the negative electrode(-) of the first cell 100a connected to the ground (GND) and the secondary fourth sensing line B₄ connected to the positive electrode(+) of the third cell 100c to measure the sum of voltages of the first, second, and third cells 100a, 100b, and 100c measured using the ground (GND) and the positive electrode (+) voltage of the third cell through the switch 300. Then, by subtracting the summed voltage values of the first and second cells 100a and 100b previously measured in the second cell voltage measurement step from the measured summation values of the voltages of the first, second, and third cells, the voltage value of the third cell 100c may be calculated.

In this way, when N battery cells are connected in series, measuring the voltage of the N-th cell allows the switch 300 to be sequentially positioned at is connected to the secondary first sensing line B₁ connected to the negative electrode (-) of the first cell 100a connected to the ground (GND) and the secondary (N+1)-th sensing line (not shown) connected to the positive electrode (+) of the N-th cell to measure the sum of the voltages of the first to N-th cells using the ground (GND) and the positive electrode (+) voltage of the N-th cell through the switch 300, and calculate the voltage value of the N-th cell by subtracting the previously measured summation values of the voltages of the first to (N-1)-th cells from the voltage summation value.

### 3. Battery Protection Method Using Battery Protection Circuit According to Present Invention

A method of protecting cells connected in series using a battery protection circuit according to the present invention may be configured as follows.

### 3.1. First Voltage Measurement Step

The monitoring IC 200 measures the primary voltage of each battery cell through primary sensing lines A₁ to A_{N+1}. Measuring the primary voltage of each battery cell in the monitoring IC 200 uses a method of measuring positive electrode (+) and negative electrode (-) voltages of the battery cells as is commonly known.

### 3.2. Second Voltage Measurement Step

The MCU 400 controls the switch 300 to measure the voltage of each battery cell secondary. Measuring the secondary voltage of the battery cell in the MCU 400 uses a method of measuring the ground (GND) and the positive electrode (+) voltage of the battery cell. More specifically, the secondary voltage of the battery cells connected in series may be measured through procedures such as the first cell voltage measurement step, the second cell voltage measurement step, and the third cell voltage measurement step described above.

### 3.3. Error Determination Step

When the primary voltage measurement in the monitoring IC 200 and the secondary voltage measurement in the MCU 400 are completed through the first and second voltage measurement steps, the primary measure voltage of the monitoring IC 200 and the secondary measured voltage of the MCU 400 are compared to each other, and whether the deviation is greater than or equal to a predetermined deviation range is compared. If it is out of the range, it is determined that an error has occurred in any one of the monitoring IC 200 and the MCU 400, and a notification alert indicating this may be provided.

Meanwhile, the above-described second voltage measurement step may be performed when the first voltage measurement step is not normally performed because the monitoring IC 200 does not operate normally. Then, the error determination step may be configured to provide a notification alert indicating that an error has occurred in the monitoring IC 200.

As such, by implementing the secondary protection configuration using the switch 300 and the MCU 400 in case the monitoring IC 200, which is the primary protection configuration, does not operate normally, it is possible to smoothly perform a protection operation to protect the battery from abnormal problems such as overcharging and overdischarging without a separate secondary protection IC.

On the other hand, although the technical idea of the present invention has been specifically described according to the above embodiment, it should be noted that the above embodiments are for the purpose of explanation and not limitation. In addition, those skilled in the art in the technical field of the present invention will be able to understand that various embodiments are possible within the scope of the spirit of the present invention.

### (description of symbols)

100a~100c: battery cell
200: monitoring IC
300: switch
400: MCU
410: SWITCH CONTROL UNIT
420: CELL VOLTAGE MEASUREMENT UNIT
430: CELL VOLTAGE CALCULATION UNIT
440: SECONDARY MONITORING UNIT

## Claims

1. A battery protection circuit configured in a battery pack in which N battery cells are connected in series with each other, and a negative pole (-) of a first cell at the lowest end among the battery cells is connected to a ground (GND), wherein N ≥ 2, the battery protection circuit comprising:
a plurality of primary sensing lines connected between positive/negative electrodes (+, -) of each battery cell and a monitoring IC;
the monitoring IC configured to perform primary monitoring by measuring a voltage of each of the battery cells through the plurality of primary sensing lines;
a plurality of secondary sensing lines connected to each of the plurality of primary sensing lines;
a switch configured to connect one secondary sensing line among the plurality of secondary sensing lines and MCU; and
the MCU configured to measure the ground (GND) and a positive electrode (+) voltage of each battery cell with a secondary sensing line connected through a control of the switch, and perform secondary monitoring by sequentially calculating voltages of the first cell to the N-th cell based on the measured ground (GND) and positive electrode (+) voltages of the battery cells.

2. The battery protection circuit of claim 1, wherein the plurality of primary sensing lines comprises:
a primary first sensing line having one end connected to the negative electrode (-) of the first cell and the other end connected to the monitoring IC;
a primary N-th sensing line having one end connected between the positive electrode (+) of the first cell and the negative electrode (-) of the N-th cell connected to an upper end of the first cell and the other end connected to the monitoring IC; and
a primary (N+1)-th sensing line having one end connected to the positive electrode (+) of the N-th cell and the other end connected to the monitoring IC.

3. The battery protection circuit of claim 2, wherein the plurality of secondary sensing lines comprise:
a secondary first sensing line having one end connected to the primary first sensing line and the other end connected to the MCU through a switch to sense a ground (GND) voltage;
a secondary N-th sensing line having one end connected to the primary N-th sensing line and the other end connected to the MCU through a switch to sense the positive electrode (+) voltage of the first cell; and
a secondary (N+1)-th sensing line having one end connected to the primary (N+1)-th sensing line and the other end connected to the MCU through a switch to sense the positive electrode (+) voltage of the N-th cell.

4. The battery protection circuit of claim 3, wherein the MCU comprises:
a switch control unit configured to sequentially locate the switch alternately from the secondary first sensing line and the secondary N-th sensing line to the (N+1)-th sensing line;
a cell voltage measurement unit configured to measure ground (GND) and positive electrode (+) voltages of a corresponding battery cell with a secondary sensing line connected through a switch under the control of the switch control unit;
a cell voltage calculation unit configured to sequentially calculate voltage values from the first cell to the N-th cell using the ground (GND) and positive electrode (+) voltages of the battery cells measured by the cell voltage measurement unit; and
a secondary monitoring unit configured to perform secondary monitoring of voltage states of the battery cells based on respective voltage values of the first to N-th cells calculated by the cell voltage calculation unit.

5. The battery protection circuit of claim 4, wherein the cell voltage measurement unit measures the ground (GND) and the positive electrode (+) voltage of the first cell through the secondary first sensing line and the secondary N-th sensing line, and
measures the ground (GND) and positive electrode (+) voltages of the N-th cell through the secondary first sensing line and the secondary (N+1)-th sensing line.

6. The battery protection circuit of claim 5, wherein the cell voltage calculation unit calculates the voltage value of the first cell from the positive electrode (+) voltage of the first cell and the ground (GND) measured by the cell voltage measurement unit,
calculates the voltage summation values of the first to N-th cells with the positive electrode (+) voltage of the N-th cell and the ground (GND) measured by the cell voltage measurement unit, and
calculates the voltage value of the N-th cell by subtracting the voltage value of the first cell from the calculated voltage summation values of the first and N-th cells.

7. A method of measuring a voltage of an N-th cell from a first cell at the lowest end among battery cells by using a switch connecting an MCU and a voltage sensing line connected to each of N battery cells connected in series, whe rein N ≥2, the method comprising:
a first cell voltage measurement step of sequentially positioning the switch to the voltage sensing line connected to a negative electrode (-) of the first cell connected to the ground (GND) and the positive electrode (+) of the first cell, respectively, to measure the voltage value of the first cell with the ground (GND) and the positive electrode (+) voltage of the first cell through the switch; and
an N-th cell voltage calculation step of sequentially positioning the switch to a voltage sensing line connected to the negative electrode (-) of the first cell connected to the ground (GND) and the positive electrode (+) of the N-th cell connected to the upper end of the first cell, respectively.

8. The method of claim 7, wherein the N-th cell voltage calculation step comprises:
measuring the voltage summation values of the first to N cells with the ground (GND) and the positive electrode (+) voltage of the N-th cell, and
calculating the voltage value of the N-th cell by subtracting the voltage value of the first cell measured in the first cell voltage measurement step from the measured first and N-th cell voltage summation values.

9. A battery protection method for protecting N (N≥2) battery cells connected in series, the method comprising:
a first voltage measurement step of measuring a primary voltage of each of the battery cells through a primary sensing line connected to each battery cell in a monitoring IC;
a second voltage measurement step of controlling a switching circuit connecting between an MCU and any one of secondary sensing lines connected to the primary sensing lines, and measuring a secondary voltage of each of the battery cells through the connected secondary sensing line;
a comparison step of comparing a primary voltage of the monitoring IC with a secondary voltage of the MCU and comparing whether a deviation is greater than or equal to a predetermined deviation reference range; and
an error determination step of providing a notification alert by determining that an error has occurred in either one of the monitoring IC and the MCU when the comparison result of the comparison step is greater than or equal to a predetermined deviation reference range.

10. The method of claim 9, wherein the second voltage measurement step comprises:
a voltage measurement step of sequentially positioning, by the MCU, the switch to a secondary sensing line connected to a negative electrode (-) of a first cell connected to the ground (GND) and the positive electrode (+) of the first cell, respectively, to measure a voltage value of the first cell with a ground (GND) and a positive electrode (+) voltage of the first cell through the switch; and
an N-th cell voltage calculation step of sequentially positioning, by the MCU, the switch to a secondary sensing line connected to the negative electrode (-) of the first cell connected to the ground (GND) and the positive electrode (+) of the N-th cell connected to the upper end of the first cell, respectively to calculate a voltage value of the N-th cell using the ground (GND) and the positive electrode (+) voltage of the N-th cell through the switch.

11. The method of claim 10, wherein the N-th cell voltage calculation step comprises
measuring the voltage summation values of the first to N cells with the ground (GND) and the positive electrode (+) voltage of the N-th cell, and
calculating the voltage value of the N-th cell by subtracting the measured first cell voltage value from the measured first and N-th cell voltage summation values.
